# EUROPÄISCHE PATENTSCHRIFT

(11) **EP 3 432 415 B1**
(45) Veröffentlichungstag und Bekanntmachung des Hinweises auf die Patenterteilung: **30.12.2020**
(21) Anmeldenummer: 18401062.7
(22) Anmeldetag: 17.07.2018
(51) Int. Cl.: H01Q 1/12, H01Q 1/32, H01Q 1/42

(54) **ANTENNENGEHÄUSE**
ANTENNA HOUSING
BOÎTIER D'ANTENNE

(30) Priorität: 17.07.2017 DE 102017116077
(43) Veröffentlichungstag der Anmeldung: 23.01.2019
(73) Patentinhaber: Reel Reinheimer Elektronik GmbH, 35625 Hüttenberg (DE)
(72) Erfinder: Reinheimer, Hans-Jörg, 35435 Wettenberg (DE)
(74) Vertreter: Stamer, Jan

(56) Entgegenhaltungen:
- EP-A2- 1 309 034
- WO-A1-2016/201208
- DE-U1-202016 107 520

## Beschreibung

Die Erfindung betrifft ein Antennengehäuse mit den Merkmalen Anspruchs 1.

Antennengehäuse dieser Art sind bekannt. Die Abdeckkappe wird üblicherweise durch eine nicht lösbare Klickverbindung mit der Montage-Plattform verbunden. Sollte eine Prüfung der Funktionsweise der eingeschlossenen Antennen-Platine mit Antennen-Strahler und- oder Strahlern ergeben, dass eine Nachjustierung wegen des durch die Abdeckkappe gebildeten Dielektrikums notwendig ist, muss die Abdeckkappe gewaltsam entfernt werden, wobei sie in der Regel zerstört wird.

Aus dem Gebrauchsmuster DE 20 2016 107 520 U1 ist ein Antennengehäuse bekannt, das aus einem mit Ultraschall verschweißbaren und dipolfreien Kunststoff besteht und das mittels eines drehgesichert in die Montage-Plattform eingesetzten, mit Hohlschaft versehenen Schraubbolzens an einem Antennengehäuse-Träger befestigt wird. Auch hier muss die Funktionsfähigkeit mit verschweißter Abdeckkappe durchgeführt werden, die sich ohne Zerstörung des Gehäuses nicht wieder entfernen lässt.

Die drehgesicherte Anordnung eines Schraubbolzens in der Montage-Plattform zur Befestigung des Antennengehäuses an einem Träger erfordert sowohl eine zusätzliche manuelle Drehsicherung am Antennengehäuse als auch das manuelle Aufschrauben einer Befestigungsmutter am Schraubbolzen. Insbesondere bei der Befestigung des Antennengehäuses an einem Kfz.-Dach werden dazu im Allgemeinen Hilfskräfte jeweils innerhalb und außerhalb des Kfz. benötigt.

Aus der Druckschrift EP 1 309 034 A2 ist eine Befestigungsvorrichtung für ein Radio an einer Antenne bekannt. An dem Radio ist ein Befestigungsring vorhanden, der eine Anzahl gleich beabstandeter Befestigungslaschen mit Auflauframpen, einem Hauptteil und einem Anschlagbereich aufweist. An der Antenne sind radial nach außen weisende Federelemente angeordnet, die durch Drehen unter die Befestigungslaschen geschoben und von diesen zur Befestigung gehalten werden.

Der Erfindung lag daher die Aufgabe zugrunde, ein Antennengehäuse zu schaffen, das einerseits eine sichere Verbindung zwischen Abdeckkappe und Montage-Plattform zur Funktionsprüfung herstellt, das bei Bedarf aber zerstörungsfrei lösbar und nach bestandener Funktionsprüfung unlösbar zum Schutz gegen Vandalismus gesichert werden kann. Die Befestigung des Antennengehäuses am Träger sollte auf jeden Fall durch eine einzige Montageperson ohne Rücksicht auf den Einbauort und auch bei Nachrüstung oder Umtausch beschädigter Antennengehäuse möglich sein.

Diese Aufgabe wird erfindungsgemäß durch die Merkmale des Anspruchs 1 gelöst. Vorteilhafte Ausgestaltungen ergeben sich aus den Merkmalen der Unteransprüche.

In der Zeichnung ist ein Ausführungsbeispiel des erfindungsgemäßen Antennengehäuses schematisch dargestellt und wird nachfolgend anhand der Figuren näher beschrieben. Dabei zeigen
Fig.1 eine perspektivische Ansicht von unten auf das Antennengehäuse,
Fig.2 eine perspektivische Ansicht auf die Oberseite der Montage-Plattform,
Fig.3 eine perspektivische Ansicht auf die Verbindungsmittel zum Antennengehäuse-Träger,
Fig.4 eine Schnittdarstellung des Antennengehäuses an einem Antennengehäuse-Träger und
Fig.5a-c die Einrast-Verbindung zwischen Montage-Plattform und Abdeckkappe.

Wesentliches Merkmal des Erfindungsgegenstandes ist die Dreh-/RastVerbindung sowohl für die Abdeckkappe an der Montage-Plattform, als auch für den Einsatz des Antennengehäuses in einen Träger. Beim Austausch älterer Einheiten gegen ein neues Antennengehäuse mit Verdrehsicherung braucht lediglich in vorgegebenem Abstand neben der Bohrung für die Durchführung des Befestigungsbolzens eine weitere Bohrung im Antennengehäuse-Träger vorgesehen zu werden.

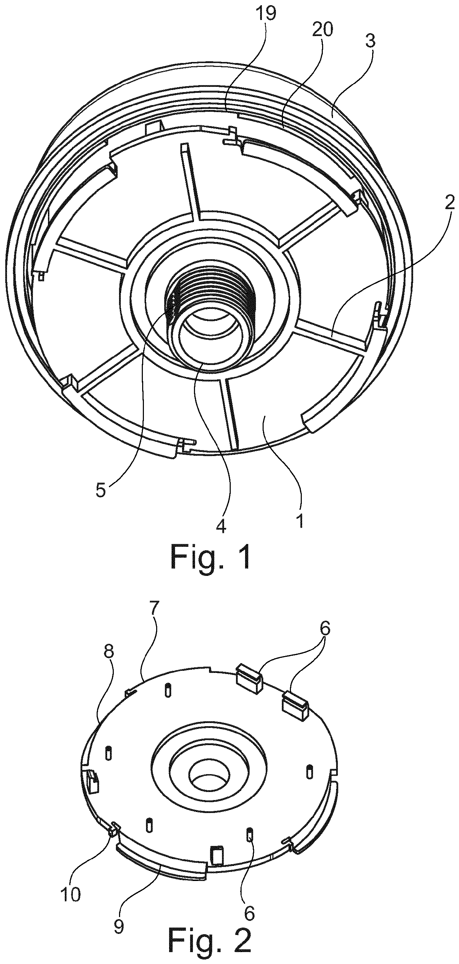

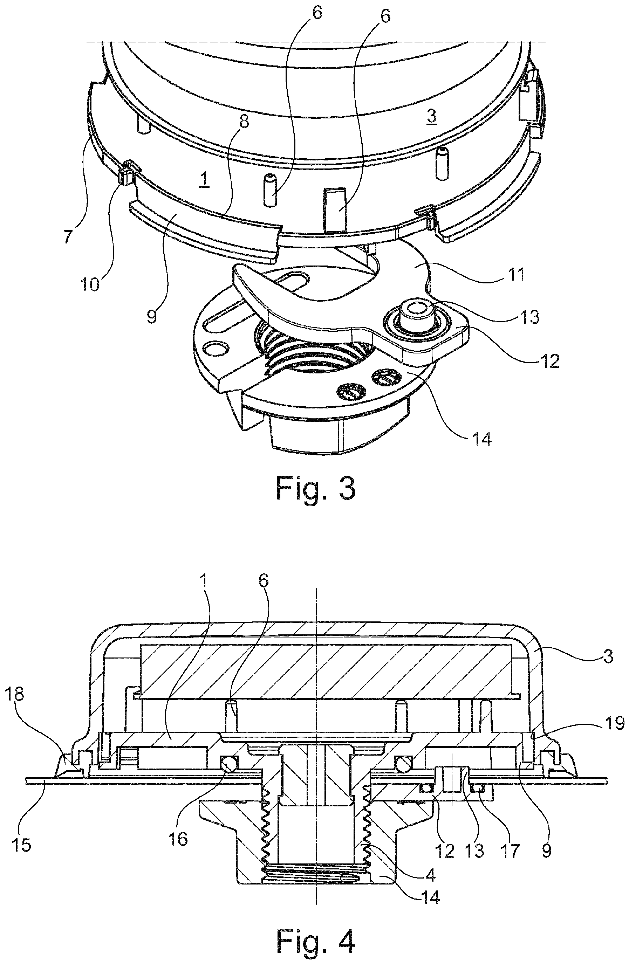

Die in Fig. 1 dargestellte perspektivische Ansicht von unten her auf das Antennengehäuse zeigt eine Montage-Plattform 1 mit radial angeordneten Verstärkungs-Rippen 2 und eine Abdeckkappe 3 zur vollständigen Überdeckung der Montage-Plattform 1. Im Zentrum der Montage-Plattform 1 ist ein Schraubbolzen 4 angeordnet. Die Montage-Plattform 1 und die Abdeckkappe 3 sind nach Einsetzen ineinander gegeneinander verdrehbar. Die Abdeckkappe 3 enthält am unteren Rand eine umlaufende Nut zum Einsetzen einer in Fig. 4 dargestellten Lippendichtung 18.

Der Schraubbolzen 4 ist an die Unterseite der Montage-Plattform 1 als Hohlbolzen senkrecht stehend fest angeformt und weist zwei parallel zueinander liegende Abflachungen 5 auf. Die Symmetrie-Ebene der Abflachungen 5 weist in einen von Verstärkungs-Rippen 2 freien Bereich an der Unterseite der Montage-Plattform 1.

Die in Fig. 2 dargestellte Ansicht auf die Oberseite der Montage-Plattform 1 zeigt Auflage- und Befestigungs-Stützen 6 für eine hier nicht dargestellte Antennen-Platine. Die Montage-Plattform 1 ist kreisförmig und an ihrem Außenrand mit verschiedenen Segmenten 7, 8 versehen, die einen unterschiedlichen Radius aufweisen.

Die Segmente 7 besitzen einen größeren Radius, der an die Einlage in die Abdeckkappe 3 angepasst ist. Die Segmente 8 weisen als Ausschnitte einen demgegenüber geringeren Radius auf. An diese Segmente 8 ist jeweils ein nach unten weisendes Winkelsegment 9 angeformt. Die Segmente 7 weisen an einem Ende jeweils Rastelemente 10 auf, die durch eine schlitzförmige Hinterschneidung als federnde Zunge ausgebildet sind. Vor dem Rastelement 10 ist das Rand-Segment 7 mit einem nach innen weisenden Abschnitt versehen, so dass der Kopf des Rastelementes 10 auf demselben Kreisbogen liegt wie das Rand-Segment 7.

Fig. 3 zeigt das unterhalb der Montage-Plattform 1 angeordnete Gabelwerkzeug 11 zum Umgreifen der Abflachungen 5 an dem hier nicht dargestellten Schraubbolzen 4. Das Gabelwerkzeug 11 ist mit einem flächigen Griffarm 12 versehen, an dem senkrecht stehend ein Zylinder-Bolzen 13 angeordnet ist. Die Achse des Zylinder-Bolzens 13 weist einen vorgegebenen Abstand zur Achse des Schraubbolzens 4 auf. Das Gabelwerkzeug 11 wird mit einer Mutter 14 an dem hier nicht dargestellten Schraubbolzen 4 in Richtung Unterseite der Montage-Plattform 1 gespannt, wobei der Zylinder-Bolzen 13 in eine Bohrung in dem Antennengehäuse-Träger 15 einrasten kann, so dass eine Drehung des Antennengehäuses wirksam verhindert wird.

Fig. 4 zeigt als Schnitt-Darstellung die Gesamt-Anordnung des Antennengehäuses auf einer Blechplatte 15 als Träger, der z.B. ein Kfz.-Dach sein kann. In die Unterseite der Montage-Plattform 1 ist ein den Schraubbolzen 4 umgreifender O-Ring 16 eingelegt, der die Montage-Plattform 1 gegenüber der Blechplatte 15 abdichtet. Ein entsprechend kleinerer O-Ring 17 ist um den Zylinder-Bolzen 13 herum angeordnet, der die Einrastung des Zylinder-Bolzens 13 in der Blechplatte 15 abdichtet. Die Abdeckkappe 3 wird durch eine an sich bekannte Lippendichtung 18 gegenüber der Blechplatte 15 abgedichtet.

Der in Fig. 4 dargestellte Querschnitt durch das Antennengehäuse schneidet die Montage-Plattform 1 in Bereichen des Rand-Segmentes 8 mit dem angeformten Winkelsegment 9. Das Rand-Segment 7 liegt auf einer umlaufenden Auflagefläche 19 innen an der Abdeckkappe 3 auf.

Dazu wird auch auf die Ansicht in Fig. 1 verwiesen, aus der auch die zur Auflagefläche 19 beabstandeten Führungsstreifen 20 zu entnehmen sind.

Nach dem Einsetzen der Montage-Plattform 1 in den Segmentbereich zwischen zwei aufeinanderfolgende Führungsstreifen 20 können die Montage-Plattform 1 und die Abdeckkappe 3 gegeneinander verdreht werden. Zunächst liegt das Winkelsegment 9 an dem Rand-Segment 8 auf einem Führungsstreifen 20 nahezu bündig mit dem Rand der Abdeckkappe 3 auf. Beim Verdrehen wird das Rand-Segment 7 unter die Führungsstreifen 20 geschoben und das Winkelsegment 9 deckt entsprechend den Einlagebereich des Rand-Segmentes 7 ab.

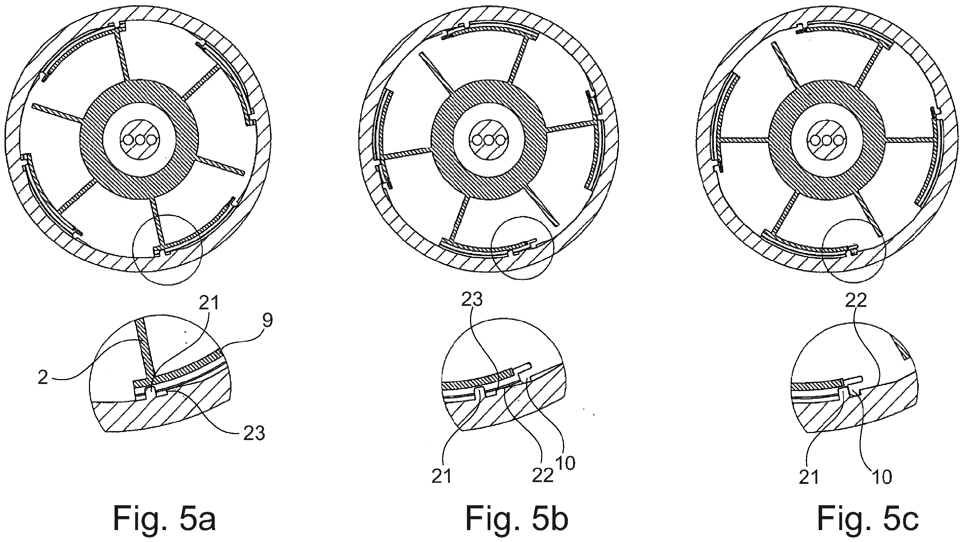

Zwischen Führungsstreifen 20 und Auflagefläche 19 ist ein die Verdrehung begrenzender Anschlagsteg 21 eingefügt, der z.B. aus Fig. 5a zu ersehen ist. In Drehrichtung vor dem Anschlagsteg 21 ist die Auflagefläche 19 in an der Abdeckkappe 3 mit einer die Wandstärke der Abdeckkappe 3 verstärkenden Auflauf-Rampe 22 mit einer vor dem Anschlagsteg 21 liegenden Sprungkante 23 versehen.

Beim Verdrehen der Abdeckkappe 3 gegenüber der Montage-Plattform 1 entsteht beim Auflaufen des Rastelementes 10 auf die Auflauf-Rampe 22 ein fühlbarer Widerstand. Die Abdeckkappe 3 kann für Testzwecke festsitzend mit der Montage-Plattform 1 verbunden werden und bei Bedarf durch Rückwärts-Drehen wieder gelöst werden. Nach bestandenem Funktionstest kann nach Überwinden des Drehwiderstandes das Rastelement 10 über die Sprungkante 23 hinweg in die Lücke zwischen Anschlagsteg 21 und Sprungkante 23 hineinspringen und sichert dann dauerhaft die Verbindung zwischen Abdeckkappe 3 und Montage-Plattform 1.

Der Verlauf zwischen Einfügen der beiden Teile ineinander (Fig. 5a) und Einrasten (Fig. 5c) ist in den Figuren 5 dargestellt. Dabei ist das Rastelement 10 mit einer federnden Zunge durch die schlitzförmige Hinterschneidung ausgeführt, so dass das Rastelement 10 beim Auflaufen auf die Auflauf-Rampe 22 in die Fläche der Montage-Plattform 1 ausweichen kann. Das Rastelement 10 kann aber auch ohne diese schlitzförmige Hinterschneidung ausgeführt sein. Zur Überwindung des Drehwiderstandes muss dann aber die Wandung der Abdeckkappe 3 nach außen gedrückt werden.

### Bezugszeichenliste

- 1: Montage-Plattform
- 2: Verstärkungs-Rippen
- 3: Abdeckkappe
- 4: Schraubbolzen
- 5: Abflachungen
- 6: Auflage-/Befestigungs-Stützen
- 7: Rand-Segment großer Radius
- 8: Rand-Segment kleinerer Radius
- 9: Winkelsegment
- 10: Rastelement
- 11: Gabelwerkzeug
- 12: Griffarm
- 13: Zylinder-Bolzen
- 14: Mutter
- 15: Blechplatte / Antennengehäuse-Träger
- 16: O-Ring
- 17: Kleinerer O-Ring
- 18: Lippendichtung
- 19: Auflagefläche in Abdeckkappe
- 20: Führungsstreifen in Abdeckkappe
- 21: Anschlagsteg
- 22: Auflauf-Rampe
- 23: Sprungkante

## Patentansprüche

1. Antennengehäuse mit
- einer kreisförmigen Montage-Plattform (1) zur Aufnahme einer Antennen-Platine auf der Oberseite, wobei die Unterseite der Montage-Plattform (1) mit radial zur Mitte verlaufenden Verstärkungs-Rippen (2) versehen ist,
- einer Abdeckkappe (3) zur vollständigen Überdeckung der Montage-Plattform (1) und
- einem im Zentrum der Montage-Plattform (1) angeordneten Schraub-Bolzen (4) zum Einsatz in einen Antennengehäuse-Träger (15), wobei
als Verbindungsvorrichtung zwischen Abdeckkappe (3) und Montage-Plattform (1) eine Dreh-/Rast-Verbindung mit einer zerstörungsfrei lösbaren ersten Drehstellung und einer durch weiteres Drehen unlösbaren Raststellung ausgebildet ist und
- der Schraub-Bolzen (4) an der Unterseite der Montage-Plattform (1) senkrecht stehend als Hohlbolzen angeformt und
- das Schraubgewinde zwei parallel zueinander liegende Abflachungen (5) aufweist.

2. Antennengehäuse nach Anspruch 1, wobei die Symmetrieebene der Abflachungen (5) in einen von Verstärkungs-Rippen (2) freien Bereich an der Unterseite der Montage-Plattform (1) weist.

3. Antennengehäuse nach Anspruch 2, wobei
- ein die Abflachungen (5) umgreifendes Gabelwerkzeug (11) mit einem flächigen Griffarm (12) vorgesehen ist, in dessen Fläche ein nach entsprechender Drehung der Montage-Plattform (1) in eine Bohrung im Antennengehäuse-Träger (15) einrastender Zylinder-Bolzen (13) angeordnet ist.

4. Antennengehäuse nach Anspruch 3, wobei
- der Schraub-Bolzen (4) von einem in der Unterseite der Montage-Plattform (1) angeordneten O-Ring (16) zur Abdichtung gegenüber dem Antennengehäuse-Träger (15) umgeben ist und
- der am Griffarm (12) des Gabelwerkzeugs (11) angeordnete Zylinder-Bolzen (13) von einem im Griffarm (12) angeordneten kleineren O-Ring (17) zur Abdichtung gegenüber dem Antennengehäuse-Träger (15) umgeben ist.

5. Antennengehäuse nach einem der vorhergehenden Ansprüche, wobei
- an der Innenseite der Abdeckkappe (3) beabstandet zum Kappenrand eine umlaufende Auflagefläche (19) angeordnet ist,
- zwischen Auflagefläche (19) und Kappenrand segmentförmige Führungsstreifen (20) nahezu gleicher Breite wie die Auflagefläche (19) zur drehbaren Einlage der Montage-Plattform (1) angeordnet sind,
- der Abstand zwischen der Auflagefläche (19) und den Führungsstreifen (20) an die Dicke der Fläche der Montage-Plattform (1) angepasst ist und
- in den Umfangsrand der Montage-Plattform (1) segmentförmige, an die Führungsstreifen (20) in Länge und Breite angepasste Ausschnitte zum Auflegen der Montage-Plattform (1) auf die Auflagefläche (19) eingefügt sind.

6. Antennengehäuse nach Anspruch 5, wobei
- in Verdrehrichtung zwischen den Führungsstreifen (20) und der Auflagefläche (19) ein die Drehung begrenzender Anschlagsteg (21) eingefügt ist.

7. Antennengehäuse nach Anspruch 5, wobei
- senkrecht zur Fläche der Montage-Plattform (1) an den Ausschnitten Winkelsegmente (9) angeformt sind, die bei Drehung zwischen Abdeckkappe (3) und Montage-Plattform (1) die Führungsstreifen (20) übergreifen und
- in ihrer Dicke im Übergreifbereich an den Abstand der Führungstreifen (20) zum Kappenrand angepasst sind.

8. Antennengehäuse Anspruch 6, wobei
- in Verdrehrichtung vor dem Anschlagsteg (21) in die Wand der Abdeckkappe (3) eine nach innen weisende Auflauf-Rampe (22) mit beabstandet vor dem Anschlagsteg (21) liegender Sprungkante (23) eingefügt ist und
- an die zwischen Führungsstreifen (20) und Auflagefläche (19) eingreifenden Segmente (7, 8) der Montage-Plattform (1) am in Verdrehrichtung vorderen, zu Anschlagsteg (21) weisenden Segmentbereich ein radial nach außen weisendes, über die Sprungkante (23) schiebbares Rastelement (10) angeformt ist.

9. Antennengehäuse nach Anspruch 8, wobei
- die Größe des Rastelements (10) an den Abstand der Sprungkante (23) zum Anschlagsteg (21) angepasst ist.

10. Antennengehäuse nach Anspruch 8 und 9, wobei
- das Rastelement (10) mit einer federnden Zunge mit Federweg in der Ebene der Montage-Plattform (1) ausgebildet ist.

## Claims

1. Antenna housing having
- a circular mounting platform (1) for accommodating an antenna board on the upper side, wherein the underside of the mounting platform (1) is provided with reinforcement ribs (2), which run radially towards the centre,
- a covering cap (3) for fully covering over the mounting platform (1), and
- a threaded bolt (4), which is arranged in the centre of the mounting platform (1) and is intended for insertion into an antenna-housing carrier (15), wherein
the connecting device formed between the covering cap (3) and mounting platform (1) is a rotary/latching connection with a first rotary position, which can be released in a nondestructive manner, and a latching position, which cannot be released by further rotation, and
- the threaded bolt (4) is formed in a vertically upright state, as a hollow bolt, on the underside of the mounting platform (1), and
- the screw thread has two flattened portions (5) located parallel to one another.

2. Antenna housing according to Claim 1, wherein
the plane of symmetry of the flattened portions (5) is oriented into a region on the underside of the mounting platform (1) which is free of reinforcement ribs (2).

3. Antenna housing according to Claim 2, wherein
- a fork tool (11) which engages around the flattened portions (5), and has a planar gripping arm (12), is provided, the surface of said gripping arm having arranged in it a cylinder bolt (13) which, following corresponding rotation of the mounting platform (1), latches into a bore in the antenna-housing carrier (15).

4. Antenna housing according to Claim 3, wherein
- the threaded bolt (4) is enclosed by an O ring (16), which is arranged in the underside of the mounting platform (1) and is intended to provide sealing in relation to the antenna-housing carrier (15), and
- the cylinder bolt (13), which is arranged on the gripping arm (12) of the fork tool (11), is enclosed by a smaller O-ring (17), which is arranged in the gripping arm (12) and is intended to provide sealing in relation to the antenna-housing carrier (15).

5. Antenna housing according to one of the preceding claims, wherein
- an encircling bearing surface (19) is arranged on the inner side of the covering cap (3), at a distance from the cap periphery,
- segment-form guide strips (20) of more or less the same width as the bearing surface (19), for rotatable introduction of the mounting platform (1), are arranged between the bearing surface (19) and cap periphery,
- the distance between the bearing surface (19) and the guide strips (20) is adapted to the thickness of the surface of the mounting platform (1), and
- segment-form cutouts which are adapted to the guide strips (20) in terms of length and width, and are intended for positioning the mounting platform (1) on the bearing surface (19), are incorporated in the circumferential periphery of the mounting platform (1).

6. Antenna housing according to Claim 5, wherein
- a rotation-limiting stop crosspiece (21) is incorporated between the guide strips (20) and the bearing surface (19), as seen in the direction of rotation.

7. Antenna housing according to Claim 5, wherein
- angled segments (9) are formed on the cutouts in a direction perpendicular to the surface of the mounting platform (1), said angled segments engaging over the guide strips (20) during rotation between the covering cap (3) and mounting platform (1) and
- being adapted in terms of thickness, in the region where they engage over said guide strips, to the distance between the guide strips (20) and the cap periphery.

8. Antenna housing according to Claim 6, wherein
- an inwardly oriented run-on ramp (22) is incorporated in the wall of the covering cap (3) in front of the stop crosspiece (21), as seen in the direction of rotation, said ramp having an offset edge (23) located at a distance in front of the stop crosspiece (21), and
- on those segments (7, 8) of the mounting platform (1) which engage between the guide strips (20) and bearing surface (19), a radially outwardly oriented latching element (10), which can be pushed over the offset edge (23), is formed on the segment region which is oriented towards the stop crosspiece (21) and is at the front, as seen in the direction of rotation.

9. Antenna housing according to Claim 8, wherein
- the size of the latching element (10) is adapted to the distance between the offset edge (23) and the stop crosspiece (21).

10. Antenna housing according to Claims 8 and 9, wherein
- the latching element (10) is formed with a resilient tongue which has resilient deflection in the plane of the mounting platform (1).

## Revendications

1. Boîtier d'antenne, comprenant
- une plate-forme de montage circulaire (1) pour recevoir une platine d'antenne sur la surface supérieure, la face inférieure de la plate-forme de montage (1) étant munie de nervures de renforcement (2) s'étendant radialement vers le centre,
- un capot (3) pour recouvrir complètement la plate-forme de montage (1), et
- un boulon fileté (4) disposé au centre de la plate-forme de montage (1) et destiné à être inséré dans un support de boîtier d'antenne (15), dans lequel un raccord tournant/à encliquetage, ayant une première position de rotation amovible sans destruction et une position d'encliquetage inamovible par une rotation supplémentaire, est réalisé comme un dispositif de raccordement entre le capot (3) et la plate-forme de montage (1), et
- le boulon fileté (4) est rapporté à la face inférieure de la plate-forme de montage (1) sous la forme d'un boulon creux en étant posé verticalement, et
- le filetage présente deux méplats (5) situés en parallèle l'un à l'autre.

2. Boîtier d'antenne selon la revendication 1, dans lequel le plan de symétrie des méplats (5) est orienté vers une zone sans nervures de renforcement (2) sur la face inférieure de la plate-forme de montage (1).

3. Boîtier d'antenne selon la revendication 2, dans lequel
- un outil à fourche (11) entourant les méplats (5) et muni d'un bras de préhension plan (12) est prévu dans la surface duquel est disposé un boulon cylindrique (13) s'encliquetant dans un perçage dans le support de boîtier d'antenne (15) après une rotation adéquate de la plate-forme de montage (1).

4. Boîtier d'antenne selon la revendication 3, dans lequel
- le boulon fileté (4) est entouré d'un joint torique (16) disposé dans la face inférieure de la plate-forme de montage (1) pour assurer l'étanchéité par rapport au support de boîtier d'antenne (15), et
- le boulon cylindrique (13) disposé sur le bras de préhension (12) de l'outil à fourche (11) est entouré d'un joint torique (17) plus petit, disposé sur le bras de préhension (12), et prévu pour assurer l'étanchéité par rapport au support de boîtier d'antenne (15).

5. Boîtier d'antenne selon l'une quelconque des revendications précédentes, dans lequel
- une surface d'appui périphérique (19) est disposée sur la face intérieure du capot (3) à distance du bord de capot,
- des bandes de guidage (20) en forme de segments, pratiquement de la même largeur que la surface d'appui (19), sont disposées entre la surface d'appui (19) et le bord de capot pour l'insertion rotative de la plate-forme de montage (1),
- la distance entre la surface d'appui (19) et les bandes de guidage (20) est adaptée à l'épaisseur de la surface de la plate-forme de montage (1), et
- des découpes en forme de segments, adaptées en longueur et en largeur aux bandes de guidage (20), sont insérées dans le bord circonférentiel de la plate-forme de montage (1) pour poser la plate-forme de montage (1) sur la surface d'appui (19).

6. Boîtier d'antenne selon la revendication 5, dans lequel
- une barrette de butée (21) limitant la rotation est insérée dans le sens de rotation entre les bandes de guidage (20) et la surface d'appui (19).

7. Boîtier d'antenne selon la revendication 5, dans lequel
- des segments angulaires (9) sont rapportés aux découpes perpendiculairement à la surface de la plate-forme de montage (1), qui chevauchent les bandes de guidage (20) lors d'une rotation entre le capot (3) et la plate-forme de montage (1), et
- qui sont adaptés en épaisseur dans la zone de chevauchement à la distance entre les bandes de guidage (20) et le bord de capot.

8. Boîtier d'antenne selon la revendication 6, dans lequel
- dans le sens de rotation, devant la barrette de butée (21), une rampe d'accès (22) tournée vers l'intérieur est insérée dans la paroi du capot (3), ladite rampe ayant un rebord (23) situé à distance de la barrette de butée (21), et
- un élément d'encliquetage (10), orienté radialement vers l'extérieur et pouvant être poussé par-dessus le rebord (23), est rapporté aux segments (7, 8) de la plate-forme de montage (1) venant en prise entre les bandes de guidage (20) et la surface d'appui (19), dans la zone de segment antérieure dans le sens de rotation et tournée vers la barrette de butée (21).

9. Boîtier d'antenne selon la revendication 8, dans lequel
- la taille de l'élément d'encliquetage (10) est adaptée à la distance entre le rebord (23) et la barrette de butée (21).

10. Boîtier d'antenne selon la revendication 8 et 9, dans lequel
- l'élément d'encliquetage (10) est réalisé avec une languette élastique ayant une course de ressort dans le plan de la plate-forme de montage (1).
